# FASCICULE DE BREVET EUROPEEN

(11) **EP 4 292 136 B1**
(45) Date de publication et mention de la délivrance du brevet: **23.04.2025**
(21) Numéro de dépôt: 22704381.7
(22) Date de dépôt: 09.02.2022
(51) Int. Cl.: H01L 31/103, H01L 31/105

(54) **PHOTODIODE GERMANIUM A CONTACTS METALLIQUES OPTIMISES**
GERMANIUM-PHOTODIODE MIT OPTIMIERTEN METALLKONTAKTEN
GERMANIUM PHOTODIODE WITH OPTIMISED METAL CONTACTS

(30) Priorité: 11.02.2021 FR 2101290
(43) Date de publication de la demande: 20.12.2023
(73) Titulaire: Commissariat à l'Energie Atomique et aux Energies Alternatives, 75015 Paris (FR)
(72) Inventeur: ALIANE, Abdelkader, 38054 GRENOBLE CEDEX 09 (FR); KAYA, Hacile, 38054 GRENOBLE CEDEX 09 (FR)
(74) Mandataire: INNOV-GROUP
(86) Numéro de dépôt international: PCT/EP2022/053073
(87) Numéro de publication internationale: WO 2022/171650

(56) Documents cités:
- EP-A1- 3 660 930
- US-A1- 2017 317 221
- ZHAO XUEWEI ET AL: "Design impact on the performance of Ge PIN photodetectors", JOURNAL OF MATERIALS SCIENCE: MATERIALS IN ELECTRONICS, CHAPMAN AND HALL, LONDON, GB, vol. 31, no. 1, 25 January 2019 (2019-01-25), pages 18 - 25, XP036992376, ISSN: 0957-4522, [retrieved on 20190125], DOI: 10.1007/S10854-018-00650-W

## Description

### DOMAINE TECHNIQUE

Le domaine de l'invention est celui des photodiodes planaires passivées réalisées à base de germanium comportant des contacts métalliques optimisés. L'invention trouve une application notamment dans le domaine de la détection d'un rayonnement lumineux dans le proche infrarouge.

### ÉTAT DE LA TECHNIQUE ANTÉRIEURE

Les dispositifs optoélectroniques de photodétection peuvent comporter une matrice de photodiodes planaires passivées. Les photodiodes s'étendent alors suivant un même plan principal, entre des première et deuxième surfaces opposées et parallèles entre elles. Elles comportent alors chacune une portion de détection, formée par exemple d'une première région en germanium dopé n et affleurant la première surface, d'une deuxième région en germanium dopé p et affleurant la deuxième surface, et d'une région intermédiaire en germanium intrinsèque ou très peu dopé p, et située entre les première et deuxième régions dopées. Une couche de passivation réalisée en un matériau diélectrique peut recouvrir la première surface dans le but de limiter la contribution du courant d'obscurité au courant électrique mesuré par chaque photodiode.

La polarisation électrique de la première région dopée n et de la deuxième région dopée p peut, dans le cas des photodiodes planaires passivées, être effectuée du côté de la première surface. Ainsi, une portion semiconductrice périphérique, par exemple réalisée en silicium polycristallin dopé p, entoure la portion de détection dans un plan principal de la photodiode et vient au contact de la deuxième région dopée p. De plus, des contacts métalliques, disposés du côté de la première surface, viennent au contact de la première région dopée n et de la portion semiconductrice périphérique dopée p.

Cependant, il apparaît qu'un contact métallique sur du germanium dopé n est de type redresseur et non pas de type ohmique, du fait du blocage du niveau de Fermi (*Fermi level pinning,* en anglais) à l'interface métal / germanium. Il existe toutefois différentes solutions pour rendre ohmique le contact métal / germanium dopé n.

Ainsi, le document de Paramahans et al. intitulé Contacts on n-type germanium using variably doped zinc oxide and highly doped indium tin oxide interfacial layers, Appl. Phys. Express 8, 051302 (2015) décrit le fait d'intercaler une très mince couche diélectrique entre le métal et le germanium dopé n, comme par exemple du ZnO d'au moins 2nm d'épaisseur ou de l'ITO d'au moins 2.4nm d'épaisseur. Par ailleurs, le document de Wu et al. intitulé Ohmic contact to n-type Ge with compositional Ti nitride, Appl. Surf. Sc. 284, 877-880 (2013) décrit une autre solution qui consiste à réaliser un contact de type TiNₓ/n-Ge avec x au moins égal à 0.8 pour obtenir un contact ohmique. Cependant, ces contacts ohmiques peuvent alors être très résistifs, ce qui dégrade les performances de la photodiode.

Par ailleurs, le document EP3657556A1 décrit une photodiode planaire passive réalisée à base de germanium, dans laquelle une portion semiconductrice intercalaire de silicium polycristallin dopé n est formée sur et au contact de la portion de détection. Elle forme un réservoir de dopants de type n destinés à diffuser dans le germanium pour réaliser la première région dopée n. Un contact métallique est réalisé sur et au contact de la portion semiconductrice intercalaire, et permet de polariser électriquement la première région dopée n.

Cependant, il existe un besoin de disposer d'une telle photodiode planaire passivée présentant des performances améliorées.

Le document EP3660930A1 décrit une photodiode PIN au germanium.

### EXPOSÉ DE L'INVENTION

L'invention a pour objectif de remédier au moins en partie aux inconvénients de l'art antérieur, et plus particulièrement de proposer un photodiode planaire passivée qui présente des performances améliorées.

Pour cela, l'objet de l'invention est une photodiode comportant :
- une portion de détection, présentant une première surface et une deuxième surface opposées l'une à l'autre et parallèles à un plan principal, réalisée en un premier matériau semiconducteur cristallin à base de germanium, comportant :
   ∘ une première région dopée de type n, et affleurant la première surface ;
   ∘ une deuxième région dopée de type p, et affleurant la deuxième surface ;
   ∘ une région intermédiaire, située entre la première région et la deuxième région et entourant la première région dans le plan principal ;
- une portion semiconductrice périphérique, réalisée en un deuxième matériau semiconducteur dopé de type p, entourant la portion de détection dans le plan principal et venant au contact de la deuxième région ;
- une portion semiconductrice intercalaire, disposée sur et au contact de la première région de la portion de détection ;
- des contacts métalliques, disposés du côté de la première surface, et adaptés à polariser électriquement, d'une part la première région par le biais de la portion semiconductrice intercalaire, et d'autre part la deuxième région par le biais de la portion semiconductrice périphérique.

Selon l'invention, la portion semiconductrice intercalaire est réalisée en un troisième matériau semiconducteur cristallin présentant : un paramètre de maille naturel égal, à 1% près, à un paramètre de maille naturel du premier matériau semiconducteur à base de germanium ; et une énergie de bandes interdites supérieure d'au moins 0.5eV à celle du premier matériau semiconducteur à base de germanium.

Certains aspects préférés mais non limitatifs de cette photodiode sont les suivants.

La portion semiconductrice intercalaire peut comporter des dopants de type n identiques à ceux présents dans la première région.

La portion semiconductrice intercalaire peut être réalisée en un composé semiconducteur cristallin III-V, et de préférence en AlAs ou en GaAs.

La portion semiconductrice intercalaire peut être située dans une échancrure de la première surface de la portion de détection, de sorte que la portion semiconductrice intercalaire est entourée, dans le plan principal par la première région.

L'un des contacts métalliques, dit contact métallique central, peut être situé sur et au contact de la portion semiconductrice intermédiaire.

La photodiode peut comporter une portion semiconductrice supérieure située sur et au contact de la portion semiconductrice intercalaire, réalisée en un matériau semiconducteur dopé de type n avec des dopants identiques à ceux de la portion semiconductrice intercalaire et de la première région.

L'un des contacts métalliques, dit contact métallique central, peut alors être situé sur et au contact de la portion semiconductrice supérieure.

La portion semiconductrice supérieure peut être réalisée en un matériau identique à celui de la portion semiconductrice périphérique.

La portion semiconductrice supérieure et la portion semiconductrice périphérique peuvent être réalisées en un matériau semiconducteur à base de silicium. La photodiode peut alors comporter une zone supérieure siliciurée au contact avec les contacts métalliques.

L'invention porte également sur un procédé de fabrication d'une photodiode selon l'une quelconque des caractéristiques précédentes, comportant les étapes suivantes
- réalisation d'un empilement comportant une première sous-couche destinée à former la deuxième région et une deuxième sous-couche destinée à former la région intermédiaire ;
- réalisation d'une couche isolante supérieure recouvrant l'empilement ;
- réalisation de la portion semiconductrice périphérique au travers de l'empilement et de la couche isolante supérieure pour déboucher sur la première sous-couche ;
- réalisation de la portion semiconductrice intercalaire par épitaxie à partir de la deuxième sous-couche de l'empilement, au travers d'une ouverture de la couche isolante supérieure.

Le procédé peut comporter, avant l'étape de réalisation de la portion semiconductrice intercalaire, une étape de réalisation d'une échancrure dans la deuxième sous-couche de l'empilement, au travers de l'ouverture, suivie de l'épitaxie de la portion semiconductrice intercalaire dans l'échancrure.

Lorsque la portion semiconductrice intercalaire est non intentionnellement dopée lors de son épitaxie, le procédé peut alors comporter les étapes suivantes :
- réalisation de la portion semiconductrice supérieure dopée de type n ;
- recuit adapté à provoquer la diffusion des dopants contenus dans la portion semiconductrice supérieure au travers de la portion semiconductrice intercalaire pour former la première région dans la portion de détection.

La portion semiconductrice supérieure et la portion semiconductrice périphérique peuvent être réalisées en un même matériau à base de silicium. Le procédé peut alors comporter une étape de réalisation des contacts métalliques de manière simultanée, l'un au contact de la portion semiconductrice supérieure, et l'autre au contact de la portion semiconductrice périphérique.

La portion semiconductrice intercalaire peut être dopée de type n lors de son épitaxie. Le procédé peut alors comporter l'étape suivante : réalisation des contacts métalliques, l'un au contact de la portion semiconductrice intercalaire, et l'autre au contact de la portion semiconductrice périphérique.

### BRÈVE DESCRIPTION DES DESSINS

D'autres aspects, buts, avantages et caractéristiques de l'invention apparaîtront mieux à la lecture de la description détaillée suivante de formes de réalisation préférées de celle-ci, donnée à titre d'exemple non limitatif, et faite en référence aux dessins annexés sur lesquels :
la figure 1A est une vue schématique et partielle, en coupe transversale, d'une photodiode planaire passivée selon un mode de réalisation, comportant un contact métallique au contact de la portion semiconductrice intercalaire, laquelle est au contact de la première région de la portion de détection ;
la figure 1B est une vue schématique et partielle, en coupe transversale, d'une photodiode planaire passivée selon une variante de réalisation, comportant une portion semiconductrice supérieure, disposée entre et au contact du contact métallique et de la portion semiconductrice intercalaire ;
les figures 2A à 2L illustrent différentes étapes d'un procédé de fabrication d'une photodiode selon le mode de réalisation illustré sur la fig.1B ;
les figures 3A à 3C illustrent différentes étapes d'un procédé de fabrication d'une photodiode selon le mode de réalisation illustré sur la fig.1A.

### EXPOSÉ DÉTAILLÉ DE MODES DE RÉALISATION PARTICULIERS

Sur les figures et dans la suite de la description, les mêmes références représentent les éléments identiques ou similaires. De plus, les différents éléments ne sont pas représentés à l'échelle de manière à privilégier la clarté des figures. Par ailleurs, les différents modes de réalisation et variantes ne sont pas exclusifs les uns des autres et peuvent être combinés entre eux. Sauf indication contraire, les termes « sensiblement », « environ », « de l'ordre de » signifient à 10% près, et de préférence à 5% près. Par ailleurs, les termes « compris entre ... et ... » et équivalents signifient que les bornes sont incluses, sauf mention contraire.

L'invention porte sur d'une manière générale sur une photodiode planaire passivée, et de préférence sur une matrice de photodiodes, ainsi que sur le procédé de fabrication. Chaque photodiode comporte une portion de détection réalisée à base de germanium, et est adaptée à détecteur un rayonnement lumineux dans le proche infrarouge (SWIR, pour *Short Wavelength IR,* en anglais) correspondant à la gamme spectrale allant de 0.8µm à 1.7µm environ, voire à 2.5µm environ.

La portion de détection des photodiodes présente une première surface et une deuxième surface opposées l'une à l'autre et parallèles à un plan principal des photodiodes. Les deux surfaces s'étendent suivant des plans identiques pour chacune des photodiodes, et délimitent verticalement (suivant l'axe d'épaisseur) la portion de détection. Les photodiodes ne présentent pas une structure en mesa dans la mesure où elles sont isolées optiquement les unes des autres par des tranchées périphériques remplies par un matériau semiconducteur dopé. Elles présentent ainsi un facteur de remplissage particulièrement élevé. Par ailleurs, elles sont dites passivées dans la mesure où la première surface est en partie recouverte par une couche diélectrique de passivation. Celle-ci contribue à réduire la composante de surface du courant d'obscurité.

D'une manière générale, la photodiode comporte :
∘ une portion de détection, réalisée en un premier matériau semiconducteur cristallin à base de germanium, et comportant : une première région dopée de type n, une deuxième région dopée de type p, et une région intermédiaire située entre les deux régions dopées et entourant la première région dopée dans un plan principal de la photodiode ;
∘ une portion semiconductrice périphérique, réalisée en un deuxième matériau semiconducteur dopé p, entourant la portion de détection dans le plan principal et venant au contact de la deuxième région dopée ;
∘ une portion semiconductrice intercalaire, disposée sur et au contact de la première région dopée n, et réalisée en un matériau semiconducteur cristallin, dopé n, et venant au contact de la première région dopée n ;
∘ des contacts métalliques, disposés du côté de la première surface, et adaptés à polariser électriquement, d'une part la première région par le biais de la portion semiconductrice intercalaire, et d'autre part, la deuxième région par le biais de la portion semiconductrice périphérique.

Le matériau semiconducteur cristallin de la portion semiconductrice intercalaire présente un paramètre de maille naturel égal à celui du premier matériau semiconducteur à base de germanium à 1% près, c'est-à-dire qu'il est égal à plus ou moins 1%, et de préférence à 0.5% près. Par paramètre de maille naturel, on entend le paramètre de maille du matériau non contraint, c'est-à-dire relaxé. Le paramètre de maille dont il est question ici est orienté dans le plan principal de la photodiode. De plus, le matériau semiconducteur cristallin de la portion semiconductrice intercalaire présente une énergie de bandes interdites supérieure d'au moins 0.5eV à celle du premier matériau semiconducteur à base de germanium. L'énergie de bandes interdites correspond à la différence d'énergie entre le minimum d'énergie de la bande de conduction et le maximum d'énergie de la bande de valence. Le matériau semiconducteur cristallin de la portion semiconductrice intercalaire est de préférence un composé III-V, par exemple un composé III-V binaire tel que de l'AlAs et du GaAs, voire un composé III-V ternaire tel que du GaAlAs ou du GaInP.

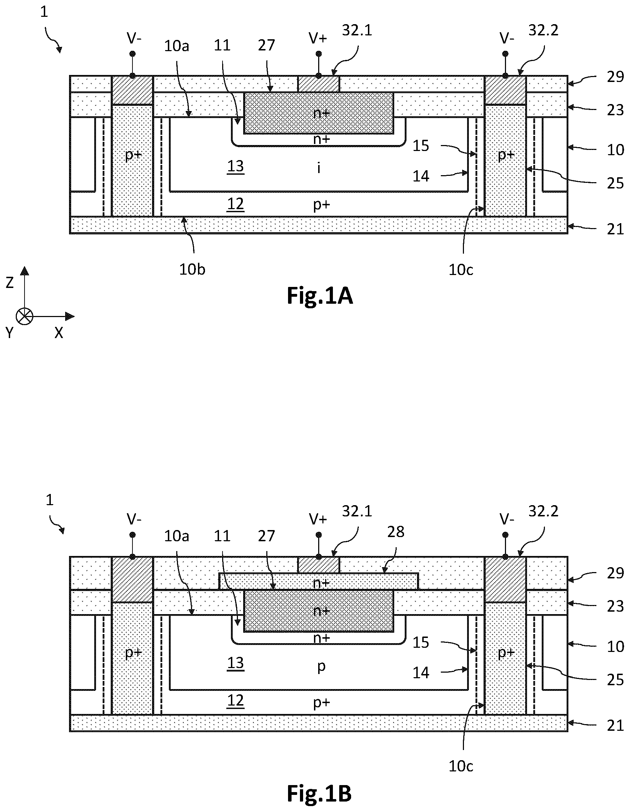

La figure 1A est une vue partielle et schématique, en coupe transversale, d'une photodiode planaire passivée 1 selon un mode de réalisation, appartenant à une matrice de photodiodes. Les photodiodes 1 sont réalisées à base de germanium, et sont polarisées en inverse à partir de la première surface 10a, tout en étant isolées les unes des autres par des tranchées remplies d'un matériau semiconducteur dopé p+. Elles comportent chacune une portion semiconductrice intercalaire 27 située ici entre et au contact d'un contact métallique 32.1 de polarisation électrique et de la première région 11 dopée n+.

On définit ici et pour la suite de la description un repère direct tridimensionnel XYZ, où les axes X et Y forment un plan parallèle au plan principal de la photodiode 1, et où l'axe Z est orienté suivant l'épaisseur de la portion de détection 1 de la photodiode, à partir de la deuxième surface 10b en direction de la première surface 10a.

La photodiode 1 comporte une portion de détection 10 s'étendant suivant l'axe Z entre une première et une deuxième surfaces de référence 10a et 10b, parallèles entre elles et opposées l'une à l'autre. Les premières surfaces 10a des photodiodes sont parallèles entre elles, et les deuxièmes surfaces 10b sont également parallèles entre elles. La première surface 10a est définie par une partie de la portion de détection 10 où affleurent la première région 11 dopée n+ ainsi que la région intermédiaire 13. La deuxième surface 10b est opposée à la première surface 10a suivant l'axe Z.

L'épaisseur maximale de la portion de détection 10, définie suivant l'axe Z entre les première et deuxième surfaces 10a, 10b est ici sensiblement constante d'une photodiode à l'autre, par exemple est comprise entre quelques centaines de nanomètres et quelques microns, par exemple entre 1µm et 5µm environ. L'épaisseur est choisie de manière à obtenir une bonne absorption dans la gamme de longueurs d'onde du rayonnement lumineux à détecter. La portion de détection 10 présente une dimension transversale dans le plan XY pouvant être comprise entre quelques centaines de nanomètres et quelques dizaines de microns, par exemple comprise entre 1µm et 20µm environ.

La portion de détection 10 est réalisée en un matériau semiconducteur cristallin, de préférence monocristallin, à base de germanium. Par à base de germanium, on entend que le matériau semiconducteur cristallin correspond au germanium ou est un composé formé d'au moins le germanium. Ainsi, les photodiodes peuvent être réalisées, par exemple, en germanium Ge, en silicium germanium SiGe, en germanium étain GeSn, voire en silicium germanium étain SiGeSn. Dans cet exemple, la portion de détection 10 est issue d'au moins une couche réalisée en germanium. Elle peut ainsi être une couche ou un substrat réalisé en le même matériau semiconducteur et présenter des régions de différents types de conductivité (homojonction) de manière à former une jonction PN ou PIN. Elle peut en variante être un empilement de sous-couches de différents matériaux semiconducteurs (hétérojonction), lesquels sont alors formés à base de germanium.

La portion de détection 10 est ainsi formée d'une première région 11 dopée de type n (n ou n+), qui affleure la première surface 10a et forme un caisson dopé de type n, et une deuxième région 12 dopée p+, qui affleure la deuxième surface 10b. Par affleurer, on entend « arriver au niveau de », ou « s'étend à partir de ». Une région intermédiaire 13 non intentionnellement dopé (dans le cas d'une jonction PIN), ou dopée p (dans le cas d'une jonction PN), est située entre et au contact des deux régions dopées 11 et 12, et entoure la première région 11 dopée n+ dans le plan principal. Dans cet exemple, la jonction semiconductrice est de type PIN, la première région 11 étant dopée de type n+, la deuxième région 12 dopée de type p+ et la région intermédiaire 13 est intrinsèque (non intentionnellement dopée).

La première région 11 dopée de type n s'étend ici à partir de la première surface 10a et est entourée par la région intrinsèque 13 dans le plan principal. Elle est distante de la bordure latérale 10c de la portion de détection 10 dans le plan XY, la bordure latérale 10c étant définie par la face interne d'une portion semiconductrice périphérique 25 dopée p+. Elle forme ainsi un caisson dopé n+ qui affleure la première surface 10a et est espacée d'une distance non nulle vis-à-vis de la bordure latérale 10c ainsi que de la deuxième surface 10b. La première région 11 dopée n+ participe ainsi à délimiter la première surface 10a. Elle peut présenter un dopage pouvant être compris entre 5.10¹⁸ et 10²¹ at/cm³ environ.

La deuxième région 12 dopée p+ s'étend dans le plan XY en affleurant la deuxième surface 10b, ici à partir de la bordure latérale 10c. Elle s'étend suivant l'axe Z à partir de la deuxième surface 10b. Elle peut présenter une épaisseur sensiblement homogène suivant l'axe Z et ainsi affleurer uniquement une zone inférieure de la bordure latérale 10c. En variante, comme illustré sur les fig.1A et 1B, la deuxième région 12 dopée p+ peut présenter une région latérale 14 dopée p+ qui affleure continûment la bordure latérale 10c suivant l'axe Z et s'étend sur toute la périphérie de la portion de détection 10. La deuxième région 12 dopée p+ peut présenter un dopage pouvant être compris entre 10¹⁸ et 10¹⁹ at/cm³ environ.

La région intermédiaire 13 est située entre les deux régions 11, 12 dopées n+ et p+, et entoure la première région 11 dopée n+ dans le plan XY. Elle est ici réalisée en un matériau semiconducteur intrinsèque de manière à former une jonction PIN mais peut être faiblement dopée p, pour former une jonction PN (cf. fig. 1B).

La photodiode 1 comporte ici une couche isolante inférieure 21, réalisée en un matériau diélectrique, recouvrant la deuxième surface 10b de la portion de détection 10, ainsi que, comme décrit plus loin, la face inférieure de la portion semiconductrice périphérique 25 dopée p+. La couche isolante inférieure 21 peut en outre être adaptée à former une fonction d'antireflet vis-à-vis du rayonnement lumineux incident. Elle forme en effet la face de réception du rayonnement lumineux destiné à être détecté.

La portion de détection 10 de la photodiode 1 est ici délimitée latéralement, dans le plan XY, par une tranchée, de préférence continue, remplie d'un matériau semiconducteur dopé p+, et formant une portion semiconductrice périphérique 25, ici dopée p+. La portion traversante périphérique 25 participe à polariser électriquement la photodiode 1, ici à partir du côté de la première surface 10a, et à pixelliser la matrice de photodiodes (isolation optique). Elle s'étend ici sur toute l'épaisseur de la portion de détection 10 pour déboucher sur la couche isolante inférieure 21, mais en variante, elle peut ne pas déboucher sur la couche isolante inférieure 21 et peut se terminer dans la deuxième région 12 dopée p+. La face interne de cette portion semiconductrice périphérique 25 dopée p+ définit alors la bordure latérale 10c de la portion de détection 10. Le matériau semiconducteur est de préférence réalisé à base de silicium, par exemple du silicium amorphe, du silicium polycristallin, du silicium germanium, voire peut être réalisé en germanium amorphe.

Une couche isolante supérieure 23 recouvre la première surface 10a de la photodiode 1, et permet d'isoler électriquement les contacts métalliques 32.1 et 32.2. Elle est ainsi au contact de la première région 11 dopée n+ ainsi que de la région intermédiaire 13. Elle est réalisée en un matériau diélectrique, tel qu'un oxyde de silicium, un nitrure de silicium, ou un oxynitrure de silicium. D'autres matériaux diélectriques peuvent être utilisés, tels qu'un oxyde d'hafnium ou d'aluminium, voire un nitrure d'aluminium, entre autres. Elle présente une épaisseur par exemple comprise entre 50nm et 500nm.

Par ailleurs, la portion de détection 10 comporte avantageusement une région latérale 14 dopée de type p+ située au niveau de la bordure latérale 10c. Cette région latérale 14 présente un niveau de dopage supérieur à celui de la région intermédiaire 13 lorsqu'elle est dopée. La région latérale 14 dopée p+ affleure la bordure latérale 10c et est au contact de la portion semiconductrice périphérique 25 dopée p+. Ainsi, la polarisation de la deuxième région 12 dopée p+ est améliorée dans la mesure où la surface de contact avec la portion semiconductrice périphérique 25 dopée p+ est augmentée. De plus, cette région latérale 14 dopée p+ permet d'éviter que la zone de charge d'espace de la photodiode 1 ne s'étende jusqu'à la bordure latérale 10c. Ainsi, on limite la contribution de cette zone (potentiellement non exempte de défauts liés à la réalisation des tranchées) au courant d'obscurité. On améliore ainsi les performances de la photodiode 1.

Par ailleurs, la portion de détection 10 est réalisée à base de germanium, par exemple est en germanium, et la portion semiconductrice périphérique 25 dopée p+ est réalisée à base de silicium, par exemple en silicium polycristallin dopé. La portion de détection 10 comporte alors avantageusement une zone latérale 15 réalisée à base de silicium germanium. La zone latérale 15 affleure la bordure latérale 10c et est au contact de la portion semiconductrice périphérique 25 dopée p+. Ainsi, la zone latérale 15 présente une énergie de bande interdite (gap) supérieure à celle de la portion de détection 10 réalisée en germanium. Cette « ouverture de gap » latérale permet de diminuer la sensibilité de la photodiode 1 aux défauts présents à proximité des tranchées. On améliore ainsi également les performances de la photodiode 1.

Par ailleurs, la photodiode 1 comporte une portion semiconductrice intercalaire 27, disposée sur et au contact de la première région 11 dopée n+. Elle est espacée d'une distance non nulle des portions semiconductrice périphérique 25 dans le plan XY et est ici entourée par la couche isolante supérieure 23. Elle est réalisée en un matériau semiconducteur cristallin dopé ici de type n+, qui présente un paramètre de maille naturel égal à 1% près, et de préférence à 0.5% près, à celui du matériau semiconducteur cristallin de la portion de détection 10, ici du germanium, et présente une énergie de bandes interdites supérieure d'au moins 0.5eV à celui du matériau semiconducteur cristallin de la portion de détection 10 (germanium). La portion semiconductrice intercalaire 27 peut ainsi être réalisée en un composé binaire ou ternaire III-V, tel que du GaAs, AlAs, GaAlAs, GaInP, entre autres.

Dans cet exemple, la portion semiconductrice intercalaire 27 est avantageusement située dans une échancrure formée dans la première surface 10a de la portion de détection 10, ce qui permet de réduire voire d'éviter la présence de défauts structuraux (dislocations) dans la portion intercalaire 27, comme décrit plus loin. En variante, elle peut reposer sur la première surface 10a qui est alors continûment plane (pas d'échancrure). La taille dans le plan XY de la portion semiconductrice intercalaire 27 dépend de la taille de la photodiode 1 : pour une photodiode de 5µm de pas, elle peut être comprise entre 0.5 et 4µm environ (et de préférence inférieure à 2µm), et pour un pas de 10µm, elle peut être comprise entre 1 et 9µm environ.

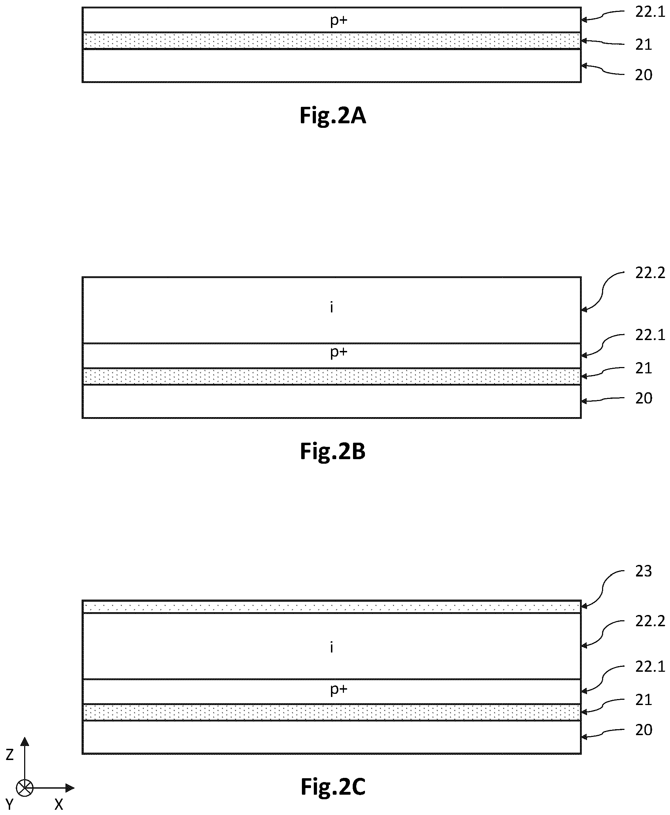

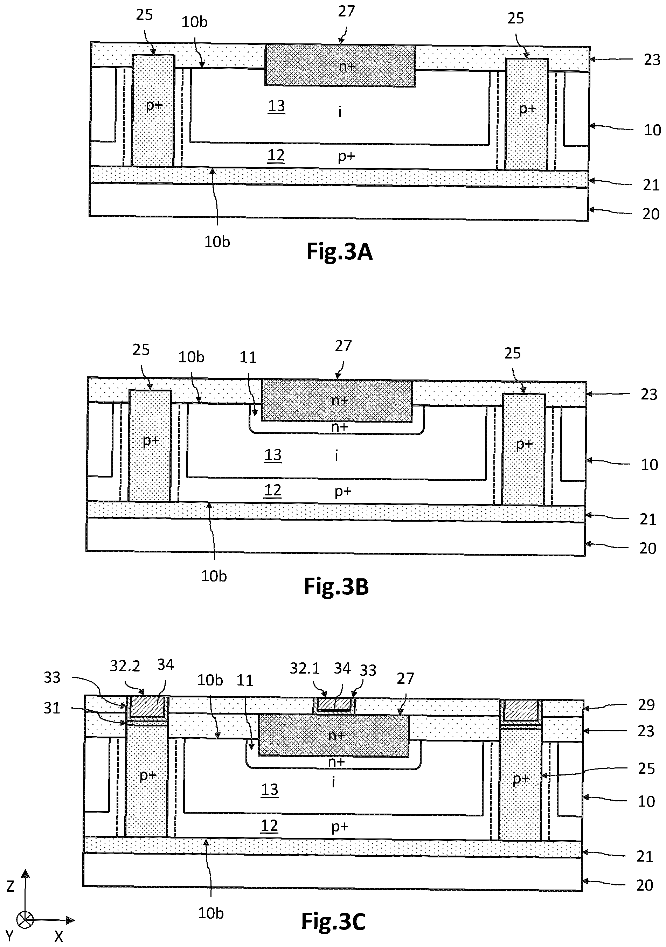

On note ici que la portion semiconductrice intercalaire 27 comporte des dopants de type n identiques à ceux présents dans la première région 11 dopée n+, dans la mesure où, comme explicité plus loin, la formation de la première région 11 est effectuée par diffusion des dopants au travers de la portion semiconductrice intercalaire 27 (cf. fig.2A à 2L) ou initialement contenus dans la portion semiconductrice intercalaire 27 (fig.3A à 3C).

La photodiode 1 comporte en outre des contacts métalliques 32.1, 32.2 permettant de la polariser en inverse à partir du côté de la première surface 10a. Ainsi, un contact métallique 32.1 est ici disposé sur et au contact de la portion semiconductrice intercalaire 27, et permet de polariser électriquement la première région 11 dopée n+. Un contact métallique 32.2 est ici disposé sur et au contact de la portion semiconductrice périphérique 25, et permet de polariser électriquement la deuxième région 12 dopée p+. Les contacts métalliques 32.1, 32.2 sont ici isolés électriquement les uns des autres dans le plan XY par la couche isolante supérieure 23 et par une couche diélectrique de passivation 29. La photodiode 1 est destinée à être polarisée en inverse, par exemple en appliquant un potentiel électrique négatif à la portion semiconductrice périphérique 25 dopée p+ et en portant la première région 11 dopée n+ à la masse.

D'une manière générale, à titre illustratif, la photodiode 1 peut présenter des dimensions dans le plan XY comprises entre 1µm et 100µm environ. L'épaisseur de la deuxième région 12 dopée p+ peut être comprise entre 20nm et 500nm environ. L'épaisseur de la région intrinsèque 13 peut être comprise entre 0.7µm et 2.5µm environ lorsque la photodiode 1 est destinée à détecter un rayonnement lumineux dans la gamme du SWIR ou du proche infrarouge (NIR). La première région 11 dopée n+ peut présenter une épaisseur comprise entre 10nm et 600nm environ. Les couches diélectriques 23 et 29 peuvent présenter ensemble une épaisseur permettant de recouvrir entièrement la face supérieure de la photodiode 1, par exemple comprise entre 10nm et 600nm environ, et l'épaisseur de la couche isolante inférieure 21 peut être comprise entre 50nm et 1µm environ.

Ainsi, la photodiode 1 présente des performances améliorées vis-à-vis des exemples de l'art antérieur mentionnés précédemment. En effet, la photodiode 1, par la présence de la portion semiconductrice intercalaire 27 située entre le contact métallique 32.1 et le germanium 11 dopé n, ne comporte pas de contact métallique sur le germanium dopé n

(première région) qui formerait alors un contact redresseur, voire un contact ohmique fortement résistif. On limite ainsi les résistances séries, ce qui permet notamment de limiter le bruit de basse fréquence. De plus, la portion semiconductrice intercalaire 27, qui est au contact de la première région 11 dopée n+, est réalisée en un matériau semiconducteur d'énergie de bandes interdites supérieure d'au moins 0.5eV à celle du germanium, ce qui permet réduire le courant d'obscurité de la photodiode 1 d'une part, et de diminuer la sensibilité de la photodiode 1 aux défauts éventuellement présents à proximité de l'échancrure dans laquelle est située la portion semiconductrice intercalaire 27. De plus, l'absence de désaccord du paramètre de maille entre le matériau cristallin de la portion semiconductrice intercalaire 27 et celui de la portion de détection 10 permet d'éviter les défauts structuraux (dislocations...) qui viendraient dégrader les performances de la photodiode 1.

La figure 1B est une vue schématique et partielle, en coupe transversale, d'une photodiode 1 selon une variante de réalisation. Dans cet exemple, la photodiode 1 se distingue de celle illustrée sur la fig.1A notamment en ce que la région intermédiaire 13 est faiblement dopée p (jonction PN), et en ce qu'une portion semiconductrice supérieure 28 est située entre et au contact du contact métallique central 32.1 et de la portion semiconductrice intercalaire 27.

Plus précisément, la portion semiconductrice intercalaire 27, comme indiqué précédemment, repose sur et au contact de la portion de détection 10. Elle est ainsi au contact de la première région 11 dopée n+. Elle est réalisée en un matériau semiconducteur cristallin présentant les propriétés mentionnées plus haut en termes d'énergie de bandes interdites et d'absence de désaccord de maille avec le germanium de la portion de détection 10. Comme indiqué plus loin, elle a été réalisée par épitaxie à partir du germanium et de manière non intentionnellement dopée.

La portion semiconductrice supérieure 28 repose donc sur et au contact de la portion semiconductrice intercalaire 27. Elle est espacée de la portion semiconductrice périphérique 25 et des contacts métalliques 32.2 dans le plan XY d'une distance non nulle. Cet espace latéral est rempli ici par la couche diélectrique de passivation 29. La portion semiconductrice supérieure 28 est réalisée en un matériau semiconducteur dopé n+, avec des dopants susceptibles de doper n+ le germanium pour former la première région 11 dopée n+, ici avec du phosphore ou de l'arsenic. Ainsi, la portion semiconductrice supérieure 28 est un réservoir de dopants destinés à diffuser, lors d'un recuit de diffusion, au travers de la portion semiconductrice intercalaire 27 pour rejoindre le germanium et former la première région 11 dopée n+. Elle est de préférence réalisée à partir de silicium polycristallin, mais d'autres matériaux polycristallins peuvent bien entendu être utilisés.

Enfin, le contact métallique 32.1 est ici disposé sur et au contact de la portion semiconductrice supérieure 28. Il permet de polariser électriquement la première région 11 dopée n+ par le biais de la portion semiconductrice supérieure 28 puis de la portion semiconductrice intercalaire 27.

Les figures 2A à 2L sont des vues schématiques et partielles, en coupe transversale, de différentes étapes d'un procédé de fabrication d'une photodiode selon l'exemple de la fig.1B. Ce procédé présente ici notamment l'avantage de réaliser les contacts métalliques 32.1 et 32.2 simultanément. Il présente également l'avantage de ne pas réaliser un dopage de la portion semiconductrice intercalaire 27 à la croissance (le contrôle de la diffusion des dopants peut être délicat) ou par implantation ionique (qui peut créer des défauts dans la portion semiconductrice intercalaire 27).

Dans cet exemple, les photodiodes 1 sont réalisées en germanium et comportent une jonction PIN, et sont adaptées à détecter un rayonnement infrarouge dans la gamme SWIR. Les photodiodes 1 sont planaires et passivées, et sont polarisées en inverse à partir de la première surface 10a, et ici au moyen d'une puce de commande 40 hybridée à la matrice de photodiode 1.

En référence à la fig.2A, on réalise une première sous-couche semiconductrice 22.1 de germanium monocristallin. La première sous-couche semiconductrice 22.1 est solidarisée à une couche support 20, ici en silicium, par l'intermédiaire d'une couche isolante inférieure 21, ici en un oxyde de silicium. Cet empilement prend la forme d'un substrat GeOI (pour *Germanium On Insulator,* en anglais). Cet empilement est de préférence réalisé au moyen du procédé décrit dans la publication de Reboud et al. intitulée Structural and optical properties of 200mm germanium-on-insulator (GeOI) substrates for silicon photonics applications, Proc. SPIE 9367, Silicon Photonics X, 936714 (February 27, 2015). Un tel procédé présente l'avantage de réaliser une sous-couche semiconductrice de germanium 22.1 présentant une absence totale ou un faible taux de défauts structuraux tels que les dislocations. Le germanium peut être non intentionnellement dopé ou être dopé, par exemple de type p. La sous-couche semiconductrice 22.1 peut présenter une épaisseur comprise entre 100nm et 500nm environ, par exemple égale à 300nm environ, et peut être recouverte d'une couche de protection (non représentée) en un oxyde de silicium. La couche isolante inférieure 21 (BOX, pour *Buried Oxide,* en anglais) peut présenter une épaisseur comprise entre 50nm et 1µm, par exemple comprise entre 100nm et 500nm, et assure avantageusement une fonction d'antireflet.

On réalise ensuite un dopage de la première sous-couche 22.1 en germanium dopé p+, par implantation ionique d'un dopant tel que le bore ou le gallium, lorsque la première sous-couche 22.1 était initialement en germanium intrinsèque. La couche de protection, le cas échéant, a été préalablement retirée par un nettoyage de surface, et la première sous-couche 22.1 de germanium peut être revêtue d'une couche d'oxyde de préimplantation (non représentée) d'une épaisseur de quelques dizaines de nanomètres, par exemple égale à 20nm. La sous-couche 22.1 de germanium présente alors un niveau de dopage compris entre 10¹⁸ et 10²⁰ at/cm³ environ. Un recuit de diffusion du dopant peut ensuite être effectué sous azote, pendant quelques minutes à quelques heures, par exemple 1h, à une température pouvant être comprise entre 600°C et 800°C, par exemple égale à 800°C. Ce recuit peut ne pas être effectué lorsque la sous-couche 22.1 était dopée à la croissance. Une autre manière de fabriquer cette couche p+ est par épitaxie d'une couche de germanium dopé en bore in situ entre 10¹⁸ et 10¹⁹ at/cm³ environ sur une sous-couche de germanium intrinsèque. Cette épitaxie peut se faire entre 400 et 800°C mais préférentiellement à 400°C.

En référence à la fig.2B, on réalise une deuxième sous-couche semiconductrice 22.2 de germanium par épitaxie à partir de la première sous-couche 22.1. Les deux sous-couches 22.1, 22.2 sont destinées à former les portions de détection 10 coplanaires en germanium de la matrice de photodiodes 1. La deuxième sous-couche 22.2 est formée par épitaxie, par exemple par dépôt chimique en phase vapeur (CVD, pour *Chemical Vapor Deposition,* en anglais) et de précédence en pression réduite (RPCVD, pour *Reduced Pressure Chemical Vapor Deposition*) ou par toute autre technique d'épitaxie. Des recuits peuvent être effectués pour diminuer le taux de dislocations dans la sous-couche 22.2. La couche d'oxyde de préimplémentation, le cas échéant, a été préalablement retirée par un nettoyage de surface. La deuxième sous-couche 22.2 de germanium est ici intrinsèque, c'est-à-dire non intentionnellement dopée dans la mesure où l'on souhaite réaliser une jonction PIN. Elle est destinée à former la zone d'absorption lumineuse des photodiodes 1. Son épaisseur dépend de la gamme de longueurs d'onde du rayonnement lumineux à détecter dans le cas d'une photodiode 1. Dans le cadre de photodiodes SWIR, la sous-couche 22.2 de germanium intrinsèque présente une épaisseur par exemple comprise entre 0,5µm et 3µm, de préférence égale à 1,5µm.

En référence à la fig.2C, on dépose une couche isolante supérieure 23 de manière à recouvrir continûment la face supérieure de la deuxième sous-couche 22.2, c'est-à-dire de manière à recouvrir les portions de détection 10 des photodiodes 1. La couche isolante supérieure 23 est réalisée en un matériau diélectrique, par exemple un oxyde, un nitrure ou un oxynitrure de silicium. Un nettoyage de la face supérieure de la deuxième sous-couche 22.2 peut avoir été effectué au préalable. La couche isolante supérieure 23 peut présenter une épaisseur comprise entre 10nm et 600nm.

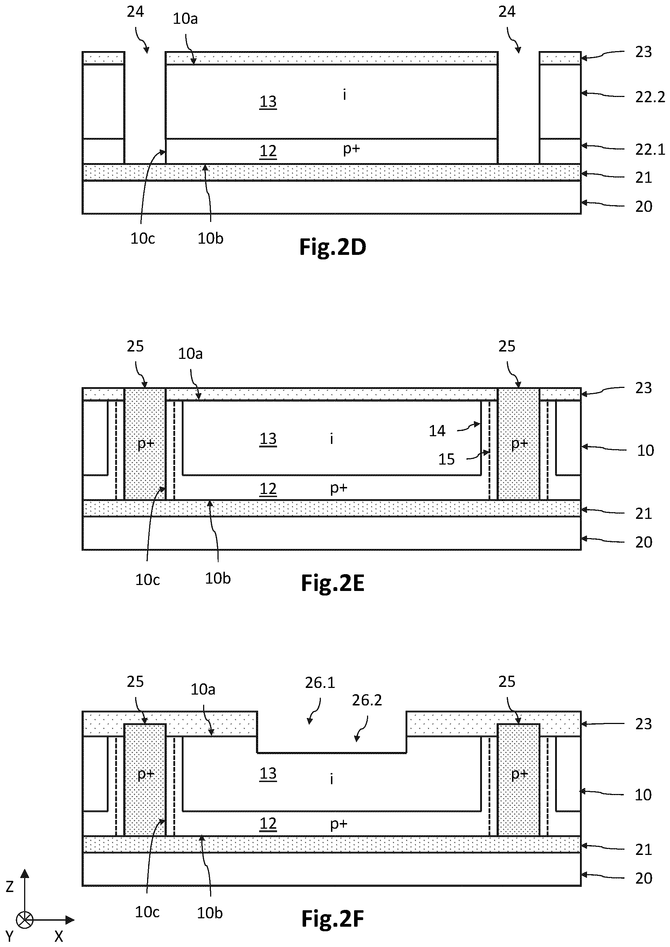

En référence à la fig.2D, on réalise, par photolithographie et gravure, les tranchées 24 destinées à pixelliser les photodiodes 1 et à participer à les polariser électriquement en inverse (au moyen des portions semiconductrices périphériques 25 qui seront ensuite réalisées). On réalise ainsi une gravure localisée de la couche isolante supérieure 23, de la sous-couche 22.2 de germanium intrinsèque, et de la sous-couche 22.1 de germanium dopé p+, jusqu'à déboucher ici sur la face supérieure de la couche isolante inférieure 21 (mais les tranchées 24 peuvent déboucher sur la sous-couche 22.1 sans la traverser). Chaque tranchée 24 s'étend ainsi de préférence continûment autour d'une photodiode 1. On obtient ainsi une pluralité de portions de détection 10 séparées les unes des autres par une tranchée continue 24. Elles sont obtenues de préférence par une technique de gravure anisotrope, de manière à obtenir une bordure latérale 10c sensiblement verticale suivant l'axe Z. Les tranchées 24 présentent une dimension transversale (largeur) dans le plan XY pouvant être comprise entre 300nm et 2µm, par exemple égale à 1µm. Les portions de détection 10 peuvent ainsi présenter une forme dans le plan XY par exemple circulaire, ovale, polygonale, par exemple carrée, ou toute autre forme.

En référence à la fig.2E, on réalise ensuite les portions semiconductrices périphériques 25. Pour cela, on dépose un matériau semiconducteur dopé de manière à remplir les tranchées 24. Le matériau semiconducteur est de préférence un matériau à base de silicium, par exemple du silicium amorphe, du silicium polycristallin, de silicium germanium, voire du germanium amorphe. Le matériau semiconducteur est dopé p+ au bore ou au gallium, avec une concentration de dopants de l'ordre de 10¹⁹ à 10²⁰ at/cm³ environ. Ainsi, le matériau semiconducteur dopé vient au contact de la bordure latérale 10c par la tranchée 24. Une étape de polissage mécanochimique (CMP) est ensuite effectuée, avec arrêt sur la face supérieure de la couche isolante supérieure 23, pour éliminer le matériau semiconducteur en excès et planariser la face supérieure formée par la couche isolante supérieure 23 et le matériau semiconducteur de la portion semiconductrice périphérique 25. On obtient ainsi une portion semiconductrice périphérique 25 dopée p+ dans chaque tranchée 24.

En référence à la fig.2F, on dépose une couche diélectrique de manière à recouvrir la surface supérieure des portions semiconductrices périphériques 25 (on augmente ainsi l'épaisseur de la couche isolante supérieure 23 qui recouvre ainsi les portions 25). Puis on réalise, par photolithographie et gravure, une ouverture traversante 26.1 au sein de la couche isolante supérieure 23 pour déboucher sur la portion de détection 10, en regard d'une zone centrale située à distance des portions semiconductrices périphériques 25 dans le plan XY. La largeur ou le diamètre de l'ouverture traversante 26.1 dépend notamment de la largeur souhaitée de la première région dopée n+. Elle peut être comprise entre 0.3µm et 5µm par exemple. De préférence, l'ouverture traversante 26.1 forme également une échancrure au sein de la portion de détection 10, par exemple d'une profondeur d'une centaine de nanomètres.

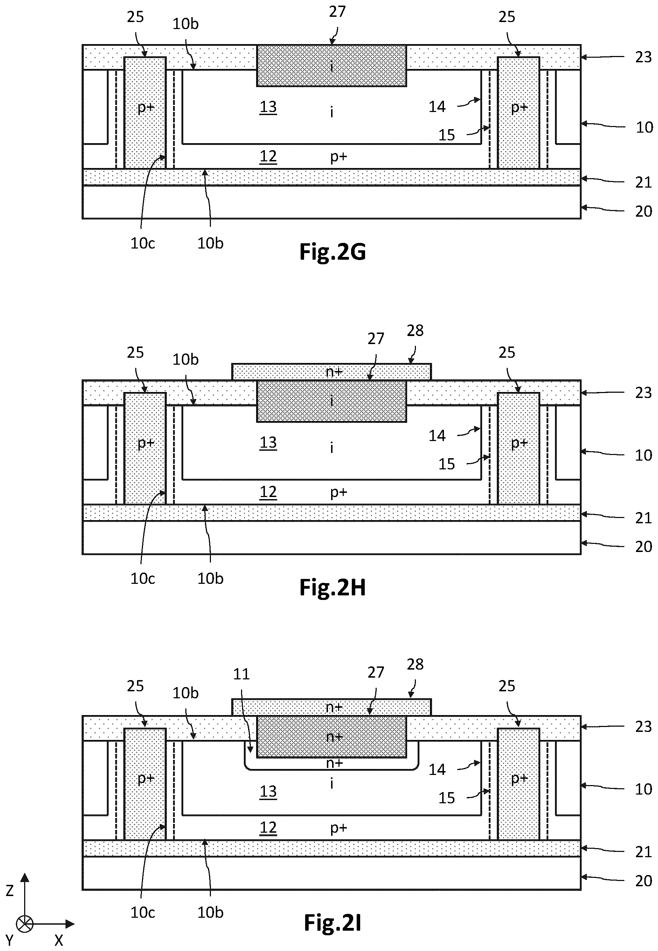

En référence à la fig.2G, on réalise une portion semiconductrice intercalaire 27, située en regard de la zone centrale de la portion de détection 10 et au contact avec celle-ci. La portion semiconductrice intercalaire 27 est réalisée par épitaxie à partir ici du germanium de la portion de détection, par exemple par épitaxie par jets moléculaires (MBE, *Molecular Beam Epitaxy,* en anglais). Elle est réalisée en un matériau semiconducteur cristallin qui présente, d'une part, un paramètre de maille quasi-identique à celui du germanium, c'est-à-dire que son paramètre de maille naturel est égal à celui du germanium à au plus 1.0% près, et de préférence à au plus 0.5% ; et d'autre part, une énergie de bandes interdites Eg supérieure (c'est-à-dire strictement supérieure) à celle Eg_{Ge} du germanium de la portion de détection.

A titre d'exemple, la portion semiconductrice intercalaire 27 est réalisée en AlAs ou en GaAs (composés stœchiométriques, c'est-à-dire que la proportion des deux éléments est identique, dont le paramètre de maille naturel est de 5.6605Å pour l'AlAs et de 5.653Â pour le GaAs, ce qui correspond respectivement à un écart de 0.044% et de 0.088% avec le paramètre de maille naturel de 5.658Â du germanium. De plus, l'énergie de bandes interdites est de 2.12eV pour l'AlAs et de 1.424eV pour le GaAs, ce qui est bien supérieur aux 0.67eV du germanium. D'autres composés semiconducteurs, par exemple ternaires, peuvent également convenir, comme par exemple le GaAlAs et le GaInP en fonction des proportions des différents éléments chimiques.

Dans cet exemple, la portion semiconductrice intercalaire 27 est intrinsèque, c'est-à-dire non intentionnellement dopée. La formation de la première région 11 dopée n+ sera obtenue par diffusion de dopants du germanium (par ex. phosphore ou arsenic) à partir d'un réservoir de dopants (la portion semiconductrice supérieure 28) au travers de la portion semiconductrice intercalaire 27).

En référence à la fig.2H, on réalise une portion semiconductrice supérieure 28, formant le réservoir de dopants de type n destinés à diffuser dans la portion de détection au travers de la portion semiconductrice intercalaire 27 pour obtenir *in fine* la première région 11 dopée n+. Elle est réalisée en un matériau semiconducteur dopé de type n+, par exemple du polysilicium ou du silicium germanium polycristallin. Elle est toutefois réalisée avantageusement en un matériau identique que celui de la portion semiconductrice périphérique, par exemple ici en polysilicium, de manière à simplifier la réalisation des contacts métalliques 32.1 et 32.2.

A titre d'exemple, la portion semiconductrice supérieure 28 est réalisée par en polysilicium dopé n+ au phosphore ou à l'arsenic, réalisé par dépôt chimique en phase vapeur à basse pression (LPCVD) entre 400°C et 650°C par exemple. Elle présente une taille dans le plan XY de préférence supérieure à celle de la portion semiconductrice intercalaire 27, et une épaisseur comprise par exemple entre 50nm et 200nm.

En référence à la fig.2I, un recuit de diffusion et d'activation des dopants est ensuite effectué, par exemple entre 500°C et 800°C et pendant 10 à 60min environ. Ainsi, les dopants (phosphore ou arsenic) diffusent au travers de la portion semiconductrice intercalaire 27 puis dans la portion de détection 10. On obtient ainsi une première région 11 dopée n+ qui s'étend au contact de la portion semiconductrice intercalaire 27, dans suivant l'axe Z que dans le plan XY.

Notons que le fait que la portion semiconductrice intercalaire 27 ait été épitaxiée dans une échancrure 26.2 de la portion de détection 10 permet de réduire le nombre de défauts structuraux (dislocations) dans la portion semiconductrice intercalaire 27 voire de les éviter. On a ainsi un matériau cristallin de meilleure qualité cristalline, ce qui améliore les performances de la photodiode.

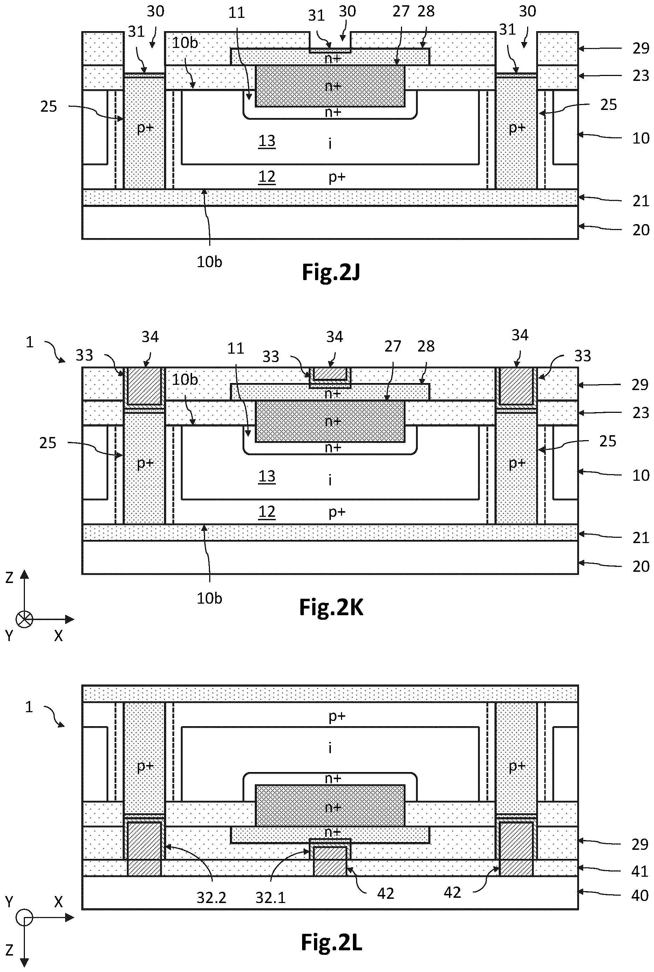

En référence à la fig.2J, on dépose une couche diélectrique de passivation 29 de manière à recouvrir la portion semiconductrice supérieure 28. La couche diélectrique peut être déposée à 400°C et être réalisée en un matériau diélectrique tel qu'un oxyde, nitrure ou oxynitrure de silicium, un oxyde ou nitrure d'aluminium, un oxyde d'hafnium, entre autres. Elle peut présenter une épaisseur comprise par exemple entre 200nm et 1000nm. Une étape de planarisation de type CMP est ensuite effectuée.

On réalise ensuite des ouvertures traversantes 30 au travers des couches diélectriques 23, 29 de manière à déboucher sur une surface supérieure de la portion semiconductrice périphérique 25 (pour réaliser ensuite le contact métallique 32.2) et sur une surface supérieure de la portion semiconductrice supérieure 28 (pour réaliser ensuite le contact métallique 32.1). Ces ouvertures traversantes 30 peuvent présenter une taille dans le plan XY comprise entre 0.1µm et 1µm, de préférence comprise entre 0.3µm et 1µm. Elles peuvent être réalisées par une gravure plasma avec un arrêt de gravure sur les surfaces en polysilicium de la portion semiconductrice supérieure 28 et de la portion semiconductrice périphérique 25. Ainsi, le fait que la portion supérieure 28 et la portion périphérique 25 soient réalisées en un même matériau, ici en silicium, permet de réaliser les contacts métalliques 32.1 et 32.2 de manière simultanée, simplifiant ainsi le procédé de fabrication.

En référence à la fig.2K, on réalise de préférence une zone siliciurée 31 de la surface supérieure de la portion semiconductrice supérieure 28, et une zone siliciurée 31 de la surface supérieure de la portion semiconductrice périphérique 25. Pour cela, on dépose au fond des ouvertures traversantes 30, 30 une couche mince de type formée d'un empilement Ni/TiN d'épaisseurs 9nm et 10nm par dépôt physique en phase vapeur (PVD), suivi d'un recuit de siliciuration entre 300°C et 350°C environ pendant 10 à 30s environ. On retire ensuite le Ni et TiN non réagi, puis on effectue un deuxième recuit de siliciuration entre 400°C et 450°C environ pendant 10 à 30s environ.

On réalise ensuite les contacts métalliques central 32.1 et latéral 32.2. On dépose ici une couche mince d'accroche 33 formée d'un empilement de type Ti/TiN/Cu par dépôt chimique en phase valeur dans les ouvertures traversantes 30.1, 30.2, et on remplit l'espace vide par du cuivre 34 déposé par électrolyse. Une étape de planarisation de type CMP est ensuite effectuée avec arrêt sur l'oxyde de la couche diélectrique de passivation 29. La couche diélectrique de passivation 29 et les contacts métalliques 32.1 et 32.2 présentent ensemble une même face supérieure planaire.

En référence à la fig.2L, on réalise l'hybridation de l'empilement optoélectronique ainsi obtenu sur une puce de commande 40. La face de connexion de la puce de commande 40 peut ainsi être revêtue d'une couche isolante 41, réalisée en un matériau diélectrique, traversée par des contacts métalliques 42. la matrice de photodiodes 1 et la puce de commande 40 sont ainsi assemblés par adhésion moléculaire hybride, par contact des faces formées des contacts métalliques et des couches isolantes. Un recuit de collage peut être effectué de manière à augmenter l'énergie de collage surfacique entre les deux faces en contact. On effectue ensuite la suppression de la couche support 20, par exemple par abrasion (*grinding,* en anglais), de manière à exposer la couche isolante inférieure 21. Celle-ci forme ainsi la face de réception du rayonnement lumineux à détecter, et assure avantageusement une fonction d'antireflet.

Le procédé de fabrication permet ainsi d'obtenir une ou plusieurs photodiodes 1 passivées, comportant chacune une portion semiconductrice intercalaire 27 au contact de la portion de détection 10, dont les propriétés en termes de paramètres de maille et d'énergie de bandes interdites, permettent d'éviter d'avoir à réaliser un contact métallique directement sur le germanium dopé n, un tel contact étant soit de type redresseur, soit de type ohmique mais fortement résistif. On réalise ainsi une ou plusieurs photodiodes 1 ayant des performances améliorées, notamment en termes de bruit basse fréquence (comme indiqué précédemment).

Les figures 3A à 3C sont des vues schématiques et partielles, en coupe transversale, de différentes étapes d'un procédé de fabrication d'une photodiode 1 selon l'exemple de la fig.1A.

La photodiode 1 se distingue de celle illustrée sur la fig.1B essentiellement en ce qu'elle ne comporte pas de portion semiconductrice supérieure 28. Aussi, le contact métallique 32.1 est sur et au contact de la portion semiconductrice intercalaire 27.

Aussi, la première région 11 dopée n+ est réalisée par diffusion de dopants à partir de la portion semiconductrice intercalaire 27 qui forme elle-même le réservoir de dopants (et non pas à partir de la portion semiconductrice supérieure 28, comme dans les figures 2A à 2L).

En référence à la fig.3A, on réalise la portion semiconductrice intercalaire 27, par croissance épitaxiale directement à partir de la portion de détection 10. Cette étape est similaire à celle de la fig.2G et s'en distingue en ce que la portion semiconductrice intercalaire 27 est dopée n+ avec des dopants adaptés à doper n le germanium de la portion de détection 10, par exemple ici avec du phosphore, de l'arsenic, voire du silicium ou du zinc. La portion semiconductrice intercalaire 27 est dopée à la croissance et non pas par implantation ionique, pour éviter toute dégradation de la qualité cristalline du matériau. Par ailleurs, les dopants ne modifient pas les propriétés du matériau de la portion semiconductrice intercalaire 27 en termes de paramètre de maille. L'énergie de bandes interdites reste supérieure d'au moins 0.5eV à celle du germanium de la portion de détection 10. Notons également que la température de l'épitaxie est contrôlée pour limiter une éventuelle diffusion des dopants dans la portion de détection 10.

En référence à la fig.3B, on réalise la première région 11 dopée n+ en effectuant un recuit de diffusion et d'activation des dopants. La température et la durée du recuit peuvent être similaires à celles mentionnées précédemment, en lien avec la fig.2I. Ainsi, les dopants diffusent à partir de la portion semiconductrice intercalaire 27 dans la portion de détection 10, ce qui forme la première région 11 dopée n+.

En référence à la fig.3C, on réalise enfin les contacts métalliques 32.1 et 32.2. On réalise tout d'abord une ouverture traversante dans les couches isolantes 23 et 29 qui débouche sur la portion semiconductrice périphérique 25, puis on réalise la zone siliciurée 31. On réalise ensuite une ouverture traversante dans la couche isolante 29 qui débouche sur la portion semiconductrice intercalaire 27. Enfin, on dépose une couche mince d'accroche 33 dans les ouvertures puis on remplit l'espace libre par du cuivre 34. On obtient ainsi les contacts métalliques 32.1 et 32.2.

Des modes de réalisation particuliers viennent d'être décrits. Différentes variantes et modifications apparaîtront à l'homme du métier.

## Revendications

1. Photodiode (1), comportant :
∘ une portion de détection (10), présentant une première surface (10a) et une deuxième surface (10b) opposées l'une à l'autre et parallèles à un plan principal, réalisée en un premier matériau semiconducteur cristallin à base de germanium, comportant :
• une première région (11) dopée de type n, et affleurant la première surface (10a) ;
• une deuxième région (12) dopée de type p, et affleurant la deuxième surface (10b) ;
• une région intermédiaire (13), située entre la première région (11) et la deuxième région (12) et entourant la première région (11) dans le plan principal ;
∘ une portion semiconductrice périphérique (25), réalisée en un deuxième matériau semiconducteur dopé de type p, entourant la portion de détection (10) dans le plan principal et venant au contact de la deuxième région (12) ;
∘ une portion semiconductrice intercalaire (27), disposée sur et au contact de la première région (11) de la portion de détection (10) ;
∘ des contacts métalliques (32.1, 32.2), disposés du côté de la première surface (10a), et adaptés à polariser électriquement, d'une part la première région (11) par le biais de la portion semiconductrice intercalaire (27), et d'autre part la deuxième région (12) par le biais de la portion semiconductrice périphérique (25) ;
∘ **caractérisée en ce que** la portion semiconductrice intercalaire (27) est réalisée en un troisième matériau semiconducteur cristallin présentant :
• un paramètre de maille naturel égal, à 1% près, à un paramètre de maille naturel du premier matériau semiconducteur à base de germanium ;
• une énergie de bandes interdites supérieure d'au moins 0.5eV à celle du premier matériau semiconducteur à base de germanium.

2. Photodiode (1) selon la revendication 1, dans laquelle la portion semiconductrice intercalaire (27) comporte des dopants de type n identiques à ceux présents dans la première région (11).

3. Photodiode (1) selon la revendication 1 ou 2, dans laquelle la portion semiconductrice intercalaire (27) est réalisée en un composé semiconducteur cristallin III-V.

4. Photodiode (1) selon la revendication 3, dans laquelle la portion semiconductrice intercalaire (27) est réalisée en AlAs ou en GaAs.

5. Photodiode (1) selon l'une quelconque des revendications 1 à 4, dans laquelle la portion semiconductrice intercalaire (27) est située dans une échancrure de la première surface (10a) de la portion de détection (10), de sorte que la portion semiconductrice intercalaire (27) est entourée, dans le plan principal par la première région (11).

6. Photodiode (1) selon l'une quelconque des revendications 1 à 5, dans laquelle l'un des contacts métalliques (32.1), dit contact métallique central, est situé sur et au contact de la portion semiconductrice intermédiaire (27).

7. Photodiode (1) selon l'une quelconque des revendications 1 à 5, comportant une portion semiconductrice supérieure (28) située sur et au contact de la portion semiconductrice intercalaire (27), réalisée en un matériau semiconducteur dopé de type n avec des dopants identiques à ceux de la portion semiconductrice intercalaire (27) et de la première région (11).

8. Photodiode (1) selon la revendication 7, dans laquelle l'un des contacts métalliques (32.1), dit contact métallique central, est situé sur et au contact de la portion semiconductrice supérieure (28).

9. Photodiode (1) selon la revendication 7 ou 8, dans laquelle la portion semiconductrice supérieure (28) est réalisée en un matériau identique à celui de la portion semiconductrice périphérique (25).

10. Photodiode (1) selon l'une quelconque des revendications 7 à 9, dans laquelle la portion semiconductrice supérieure (28) et la portion semiconductrice périphérique (25) sont réalisées en un matériau semiconducteur à base de silicium, et comporte une zone supérieure (31) siliciurée au contact avec les contacts métalliques (32.1, 32.2).

11. Procédé de fabrication d'une photodiode selon l'une quelconque des revendications précédentes, comportant les étapes suivantes :
∘ réalisation d'un empilement comportant une première sous-couche (22.1) destinée à former la deuxième région (12) et une deuxième sous-couche (22.2) destinée à former la région intermédiaire (13) ;
∘ réalisation d'une couche isolante supérieure (23) recouvrant l'empilement ;
∘ réalisation de la portion semiconductrice périphérique (25) au travers de l'empilement et de la couche isolante supérieure (23) pour déboucher sur la première sous-couche (22.1);
∘ réalisation de la portion semiconductrice intercalaire (27) par épitaxie à partir de la deuxième sous-couche (22.2) de l'empilement, au travers d'une ouverture (26.1) de la couche isolante supérieure (23).

12. Procédé de fabrication selon la revendication 11, comportant, avant l'étape de réalisation de la portion semiconductrice intercalaire (27), une étape de réalisation d'une échancrure (26.2) dans la deuxième sous-couche (22.2) de l'empilement, au travers de l'ouverture (26.1), suivie de l'épitaxie de la portion semiconductrice intercalaire (27) dans l'échancrure (26.2).

13. Procédé de fabrication selon la revendication 11 ou 12, dans lequel la portion semiconductrice intercalaire (27) est non intentionnellement dopée lors de son épitaxie, le procédé comportant les étapes suivantes :
∘ réalisation de la portion semiconductrice supérieure (28) dopée de type n ;
∘ recuit adapté à provoquer la diffusion des dopants contenus dans la portion semiconductrice supérieure (28) au travers de la portion semiconductrice intercalaire (27) pour former la première région (11) dans la portion de détection (10).

14. Procédé de fabrication selon la revendication 13, dans lequel la portion semiconductrice supérieure (28) et la portion semiconductrice périphérique (25) sont réalisées en un même matériau à base de silicium, le procédé comportant en outre l'étape suivante :
∘ réalisation des contacts métalliques (32.1, 32.2) de manière simultanée, l'un (32.1) au contact de la portion semiconductrice supérieure (28), et l'autre (32.2) au contact de la portion semiconductrice périphérique (25).

15. Procédé de fabrication selon la revendication 11 ou 12, dans lequel la portion semiconductrice intercalaire (27) est dopée de type n lors de son épitaxie, le procédé comportant l'étape suivante :
∘ réalisation des contacts métalliques (32.1, 32.2), l'un (32.1) au contact de la portion semiconductrice intercalaire (27), et l'autre (32.2) au contact de la portion semiconductrice périphérique (25).

## Patentansprüche

1. Photodiode (1), umfassend:
∘einen Detektionsabschnitt (10), der eine erste Oberfläche (10a) und eine zweite Oberfläche (10b) aufweist, die entgegengesetzt zueinander und parallel zu einer Hauptebene sind, und der aus einem kristallinen ersten Halbleitermaterial auf Germaniumbasis ausgeführt ist, umfassend:
• eine erste Region (11), die n-dotiert ist und bündig zu der ersten Oberfläche (10a) ist;
• eine zweite Region (12), die p-dotiert ist und bündig zu der zweiten Oberfläche (10b) ist;
• eine Zwischenregion (13), die zwischen der ersten Region (11) und der zweiten Region (12) gelegen ist und die erste Region (11) in der Hauptebene umgibt;
∘ einen umfänglichen Halbleiterabschnitt (25), der aus einem p-dotierten zweiten Halbleitermaterial ausgeführt ist, den Detektionsabschnitt (10) in der Hauptebene umgibt und in Kontakt mit der zweiten Region (12) gelangt;
∘ einen dazwischen liegenden Halbleiterabschnitt (27), der auf und in Kontakt mit der ersten Region (11) des Detektionsabschnitts (10) angeordnet ist;
∘ Metallkontakte (32.1, 32.2), die auf der Seite der ersten Oberfläche (10a) angeordnet sind und dazu angepasst sind, zum einen die erste Region (11) über den dazwischen liegenden Halbleiterabschnitt (27) und zum anderen die zweite Region (12) über den umfänglichen Halbleiterabschnitt (25) elektrisch zu polarisieren;
∘ **dadurch gekennzeichnet, dass** der dazwischen liegende Halbleiterabschnitt (27) aus einem kristallinen dritten Halbleitermaterial ausgeführt ist, aufweisend:
• einen natürlichen Gitterparameter, der bis auf 1 % gleich einem natürlichen Gitterparameter des ersten Halbleitermaterials auf Germaniumbasis ist;
• eine Bandlückenenergie, die um mindestens 0,5 eV größer als die des ersten Halbleitermaterials auf Germaniumbasis ist.

2. Photodiode (1) nach Anspruch 1, wobei der dazwischen liegende Halbleiterabschnitt (27) n-Dotierungsstoffe umfasst, die identisch mit den in der ersten Region (11) vorhandenen sind.

3. Photodiode (1) nach Anspruch 1 oder 2, wobei der dazwischen liegende Halbleiterabschnitt (27) aus einer kristallinen III-V-Halbleiterverbindung ausgeführt ist.

4. Photodiode (1) nach Anspruch 3, wobei der dazwischen liegende Halbleiterabschnitt (27) aus AlAs oder aus GaAs ausgeführt ist.

5. Photodiode (1) nach einem der Ansprüche 1 bis 4, wobei der dazwischen liegende Halbleiterabschnitt (27) in einem Ausschnitt der ersten Oberfläche (10a) des Detektionsabschnitts (10) gelegen ist, so dass der dazwischen liegende Halbleiterabschnitt (27) in der Hauptebene von der ersten Region (11) umgeben ist.

6. Photodiode (1) nach einem der Ansprüche 1 bis 5, wobei einer der Metallkontakte (32.1), zentraler Metallkontakt genannt, auf und in Kontakt mit dem dazwischen liegenden Halbleiterabschnitt (27) gelegen ist.

7. Photodiode (1) nach einem der Ansprüche 1 bis 5, umfassend einen oberen Halbleiterabschnitt (27), der auf und in Kontakt mit dem dazwischen liegenden Halbleiterabschnitt (27) gelegen ist und aus einem n-dotierten Halbleitermaterial mit Dotierungsstoffen ausgeführt ist, die identisch mit denen des dazwischen liegenden Halbleiterabschnitts (27) und der ersten Region (11) sind.

8. Photodiode (1) nach Anspruch 7, wobei einer der Metallkontakte (32.1), zentraler Metallkontakt genannt, auf und in Kontakt mit dem oberen Halbleiterabschnitt (28) gelegen ist.

9. Photodiode (1) nach Anspruch 7 oder 8, wobei der obere Halbleiterabschnitt (28) aus einem Material ausgeführt ist, das identisch mit dem des umfänglichen Halbleiterabschnitts (25) ist.

10. Photodiode (1) nach einem der Ansprüche 7 bis 9, wobei der obere Halbleiterabschnitt (27) und der umfängliche Halbleiterabschnitt (25) aus einem Halbleitermaterial auf Siliziumbasis ausgeführt sind und umfassend einen silizidierten oberen Bereich (31) in Kontakt mit den Metallkontakten (32.1, 32.2).

11. Verfahren zur Herstellung einer Photodiode nach einem der vorhergehenden Ansprüche, umfassend die folgenden Schritte
∘ Ausführen eines Schichtsystems, umfassend eine erste Teilschicht (22.1), die dazu bestimmt ist, die zweite Region (12) zu bilden, und eine zweite Teilschicht (22.2), die dazu bestimmt ist, die dazwischen liegende Region (13) zu bilden;
∘Ausführen einer oberen isolierenden Schicht (23), die das Schichtsystem bedeckt;
∘ Ausführen des umfänglichen Halbleiterabschnitts (25) durch das Schichtsystem und die obere isolierende Schicht (23) hindurch, um auf der ersten Teilschicht (22.1) zu münden;
∘ Ausführen des dazwischen liegenden Halbleiterabschnitts (27) durch Epitaxie ausgehend von der zweiten Teilschicht (22.2) des Schichtsystems durch eine Öffnung (26.1) der oberen isolierenden Schicht (23) hindurch.

12. Verfahren zur Herstellung nach Anspruch 11, umfassend, vor dem Schritt des Ausführens des dazwischen liegenden Halbleiterabschnitts (27), einen Schritt des Ausführens eines Ausschnitts (26.2) in der zweiten Teilschicht (22.2) des Schichtsystems durch die Öffnung (26.1) hindurch, gefolgt von der Epitaxie des dazwischen liegenden Halbleiterabschnitts (27) in dem Ausschnitt (26.2).

13. Verfahren zur Herstellung nach Anspruch 11 oder 12, wobei der dazwischen liegende Halbleiterabschnitt (27) bei seiner Epitaxie nicht absichtlich dotiert wird, wobei das Verfahren die folgenden Schritte umfasst:
∘ Ausführen des n-dotierten oberen Halbleiterabschnitts (28);
∘ Glühen, das dazu angepasst ist, die Diffusion der in dem oberen Halbleiterabschnitt (28) enthaltenen Dotierungsstoffe durch den dazwischen liegenden Halbleiterabschnitt (27) zu veranlassen, um die erste Region (11) in dem Detektionsabschnitt (10) zu bilden.

14. Verfahren zur Herstellung nach Anspruch 13, wobei der obere Halbleiterabschnitt (28) und der umfängliche Halbleiterabschnitt (25) aus einem selben Material auf Siliziumbasis ausgeführt sind, wobei das Verfahren ferner den folgenden Schritt umfasst:
∘ gleichzeitiges Ausführen der Metallkontakte (32.1, 32.2), einen (32.1) in Kontakt mit dem oberen Halbleiterabschnitt (28) und den anderen (32.2) in Kontakt mit dem umfänglichen Halbleiterabschnitt (25).

15. Verfahren zur Herstellung nach Anspruch 11 oder 12, wobei der dazwischen liegende Halbleiterabschnitt (27) bei seiner Epitaxie n-dotiert wird, wobei das Verfahren den folgenden Schritt umfasst:
∘Ausführen der Metallkontakte (32.1, 32.2), einen (32.1) in Kontakt mit dem dazwischen liegenden Halbleiterabschnitt (27) und den anderen (32.2) in Kontakt mit dem umfänglichen Halbleiterabschnitt (25).

## Claims

1. Photodiode (1), comprising:
∘ a detection portion (10), having a first surface (10a) and a second surface (10b) opposite each other and parallel to a main plane, made of a first germanium-based crystalline semiconductor material, comprising:
• a first n-type doped region (11), and flush with the first surface (10a);
• a second p-type doped region (12), and flush with the second surface (10b);
• an intermediate region (13), located between the first region (11) and the second region (12) and surrounding the first region (11) in the main plane;
o a peripheral semiconductor portion (25), made of a second p-type doped semiconductor material, surrounding the detection portion (10) in the main plane and coming into contact with the second region (12);
o an interposed semiconductor portion (27), disposed on and in contact with the first region (11) of the detection portion (10);
o metal contacts (32.1, 32.2), disposed on the side of the first surface (10a), and adapted to electrically bias, on the one hand, the first region (11) by means of the interposed semiconductor portion (27) and, on the other hand, the second region (12) by means of the peripheral semiconductor portion (25);
o **characterized in that** the interposed semiconductor portion (27) is made of a third crystalline semiconductor material having:
• a natural lattice parameter equal, to within 1%, to a natural lattice parameter of the first germanium-based semiconductor material;
• a bandgap energy at least 0.5 eV higher than that of the first germanium-based semiconductor material.

2. Photodiode (1) according to Claim 1, wherein the interposed semiconductor portion (27) comprises n-type dopants identical to those present in the first region (11).

3. Photodiode (1) according to Claim 1 or 2, wherein the interposed semiconductor portion (27) is made of a III-V crystalline semiconductor compound.

4. Photodiode (1) according to Claim 3, wherein the interposed semiconductor portion (27) is made of AlAs or GaAs.

5. Photodiode (1) according to any one of Claims 1 to 4, wherein the interposed semiconductor portion (27) is located in a notch of the first surface (10a) of the detection portion (10) so that the interposed semiconductor portion (27) is surrounded, in the main plane, by the first region (11).

6. **Photodiode** (1) according to any one of Claims 1 to 5, wherein one of the metal contacts (32.1), called central metal contact, is located on and in contact with the intermediate semiconductor portion (27).

7. Photodiode (1) according to any one of Claims 1 to 5, comprising an upper semiconductor portion (28) located on and in contact with the interposed semiconductor portion (27), made of an n-type doped semiconductor material with dopants identical to those of the interposed semiconductor portion (27) and of the first region (11).

8. Photodiode (1) according to Claim 7, wherein one of the metal contacts (32.1), called central metal contact, is located on and in contact with the upper semiconductor portion (28).

9. Photodiode (1) according to Claim 7 or 8, wherein the upper semiconductor portion (28) is made of a material identical to that of the peripheral semiconductor portion (25).

10. Photodiode (1) according to any one of Claims 7 to 9, wherein the upper semiconductor portion (28) and the peripheral semiconductor portion (25) are made of a silicon-based semiconductor material and comprising a silicided upper zone (31) in contact with the metal contacts (32.1, 32.2).

11. Method for manufacturing a photodiode according to any one of the preceding claims, comprising the following steps:
∘ producing a stack comprising a first sub-layer (22.1) intended to form the second region (12) and a second sub-layer (22.2) intended to form the intermediate region (13);
∘producing an upper insulating layer (23) covering the stack;
∘ producing the peripheral semiconductor portion (25) through the stack and the upper insulating layer (23) in order to emerge onto the first sub-layer (22.1);
∘ producing the interposed semiconductor portion (27) by epitaxy from the second sub-layer (22.2) of the stack, through an opening (26.1) of the upper insulating layer (23).

12. Manufacturing method according to Claim 11, comprising, before the step of producing the interposed semiconductor portion (27), a step of producing a notch (26.2) in the second sub-layer (22.2) of the stack, through the opening (26.1), followed by epitaxy of the interposed semiconductor portion (27) in the notch (26.2).

13. **Manufacturing** method according to Claim 11 or 12, wherein the interposed semiconductor portion (27) is unintentionally doped during the epitaxy thereof, the method comprising the following steps:
∘ producing the n-type doped upper semiconductor portion (28);
∘ annealing adapted to cause diffusion of the dopants contained in the upper semiconductor portion (28) through the interposed semiconductor portion (27) in order to form the first region (11) in the detection portion (10).

14. Manufacturing method according to Claim 13, wherein the upper semiconductor portion (28) and the peripheral semiconductor portion (25) are made of the same silicon-based material, the method further comprising the following step:
∘ simultaneously producing metal contacts (32.1, 32.2), one (32.1) in contact with the upper semiconductor portion (28), and the other (32.2) in contact with the peripheral semiconductor portion (25).

15. Manufacturing method according to Claim 11 or 12, wherein the interposed semiconductor portion (27) is n-type doped during the epitaxy thereof, the method comprising the following step:
∘ producing metal contacts (32.1, 32.2), one (32.1) in contact with the interposed semiconductor portion (27), and the other (32.2) in contact with the peripheral semiconductor portion (25).
